# EUROPEAN PATENT APPLICATION

(11) **EP 4 580 331 A1**
(43) Date of publication of application: **02.07.2025**
(21) Application number: 24210791.0
(22) Date of filing: 05.11.2024
(51) Int. Cl.: H10D 1/00, H01L 23/522, H10D 1/68, H10D 84/80

(54) **TRENCH CAPACITOR IN INTERCONNECT REGION**

(30) Priority: 27.12.2023 US 202318397682
(71) Applicant: INTEL Corporation, Santa Clara, CA 95054 (US)
(72) Inventor: FROST, Denzil S., Rio Rancho, 87124 (US); CHE-YUN, Lin, Milwaukie, 97222 (US); MALYAVANATHAM, Gokul, Hillsboro, 97124 (US); SEGHETE, Dragos, Portland, 97221 (US); YAUNG, Jack, Hillsboro, 97123 (US)
(74) Representative: Goddar, Heinz J.

(57) **Abstract**

Techniques are provided herein for forming one or more MIM trench capacitors in the interconnect region above the device layer of an integrated circuit. In an example, the MIM trench capacitor(s) are formed within one of the upper interconnect layers of the interconnect region, and thus can have a relatively high height (e.g., greater than about 200 nm). An interconnect layer included in a stack of interconnect layers includes a MIM capacitor having a first electrode (206), a capacitor dielectric (210) on the first electrode, and a second electrode (212) on the capacitor dielectric. The MIM capacitor runs along the outside surface of a plurality of dielectric fins (204), which greatly increases the surface area of the capacitor within a relatively small plan footprint. The first and second electrodes may connect with one or more topside contacts (216, 218) and/or one or more buried conductive lines (220, 222).

## Description

### BACKGROUND

As integrated circuits continue to scale downward in size, a number of challenges arise. As density of devices increases, the available space on a given die dwindles rapidly. Some structures require a certain amount of space to operate effectively, but the limited available footprint on a die makes arranging these structures challenging. Accordingly, there remain a number of non-trivial challenges with respect to fabricating certain structures in an integrated circuit.

### BRIEF DESCRIPTION OF THE DRAWINGS

Figure 1 is a cross-sectional view that illustrates an example portion of an integrated circuit configured with an interconnect region over a plurality of semiconductor devices, in accordance with an embodiment of the present disclosure.
Figures 2A - 2C are cross-sectional views of different arrangements for a metal-insulator-metal (MIM) trench capacitor in an interconnect layer of the interconnect region, in accordance with some embodiments of the present disclosure.
Figures 3A - 3F are cross-sectional views that collectively illustrate an example process for forming a MIM trench capacitor in the interconnect region, in accordance with some embodiments of the present disclosure.
Figure 4 illustrates a cross-section view of a chip package containing one or more semiconductor dies, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein for forming one or more MIM trench capacitors in the interconnect region above the device layer of an integrated circuit. Although the techniques can be used in any number of integrated circuit applications, they are particularly useful with respect to forming metal-insulator-metal (MIM) devices. In some examples, the MIM trench capacitor(s) are formed within one of the upper interconnect layers (e.g., within one of the top three interconnect layers) of the interconnect region, and thus can have a relatively high height (e.g., greater than about 200 nm). According to some such embodiments, an interconnect layer included in a stack of interconnect layers includes a MIM capacitor having a first electrode, a capacitor dielectric on the first electrode, and a second electrode on the capacitor dielectric. The MIM capacitor runs along the outside surface of a plurality of dielectric fins, which greatly increases the surface area of the capacitor within a relatively small plan footprint. The first and second electrodes may connect with topside contacts or one or more buried conductive lines. Numerous configurations and variations will be apparent in light of this disclosure.

### General Overview

As previously noted above, it can be challenging to provide effective area scaling for capacitor structures. Passive metal-insulator-metal (MIM) capacitors protect against power delivery noise and can provide a charge reservoir close to the transistors. Their performance is measured in capacitance/area. Typical MIM capacitors stack electrode and high-K dielectric films in a planar fashion, which makes the capacitance directly dependent on the occupied 2D area. However, it becomes increasingly challenging to integrate such capacitors in densely packed devices with limited available footprint.

Thus, techniques are provided herein for forming MIM trench capacitors within the interconnect region above the semiconductor devices. The interconnect region includes a stack of interconnect layers having conductive structures for routing signal and power/ground rails between the various semiconductor devices. According to some embodiments, MIM trench capacitors may be formed within one of the interconnect layers to free up more space in the device layer (e.g., where the semiconductor devices are located). Furthermore, the trench-based design of the MIM capacitors increases the capacitance due to the increase in surface area without causing a large increase in the plan footprint of the capacitor. Various contact designs may be used to form conductive contacts to the MIM capacitor electrodes. Topside contacts and/or vias extending down to bottom-side metal lines may be provided to make electrical contact with the capacitor electrodes.

According to an embodiment, an integrated circuit includes a plurality of semiconductor devices, an interconnect region above the plurality of semiconductor devices having a plurality of interconnect layers, and a metal-insulator-metal (MIM) capacitor in the interconnect region. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer is conformal on the first electrode along the sidewalls and the top surfaces of the plurality of parallel dielectric fins, and the second electrode is conformal on the capacitor dielectric layer along the sidewalls and the top surfaces of the plurality of parallel dielectric fins.

According to another embodiment, an electronic device includes a chip package having one or more dies. At least one of the one or more dies includes an interconnect region above a plurality of semiconductor devices and having a plurality of interconnect layers, and a MIM capacitor in an interconnect layer of the plurality of interconnect layers. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer follows the first electrode along the sidewalls and the top surfaces of the plurality of parallel dielectric fins, and the second electrode follows the capacitor dielectric layer along the sidewalls and the top surfaces of the plurality of parallel dielectric fins.

According to another embodiment, an integrated circuit includes a plurality of semiconductor devices, an interconnect region above the plurality of semiconductor devices and having a plurality of stacked interconnect layers, an interconnect layer of the plurality of stacked interconnect layers and having a dielectric layer with a thickness of at least 1 micrometer, and a MIM capacitor embedded in the dielectric layer. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer follows the first electrode along the sidewalls and the top surfaces of the plurality of parallel dielectric fins, and the second electrode follows the capacitor dielectric layer along the sidewalls and the top surfaces of the plurality of parallel dielectric fins.

The techniques can be used with any type of planar and non-planar transistors, including finFETs (sometimes called double-gate transistors, or tri-gate transistors), nanowire and nanoribbon transistors (sometimes called gate-all-around transistors), and thin film transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a remove metal gate, or RMG, process). Any number of semiconductor materials can be used in forming the transistors to which power is being supplied by a buried or backside power rail, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of relatively large (e.g., at least 500 nm in height) accordion-like MIM capacitors within the interconnect region. In some examples, the MIM capacitors may be located within one of the upper layers of the interconnect region (e.g., within the top three interconnect layers of the interconnect region).

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

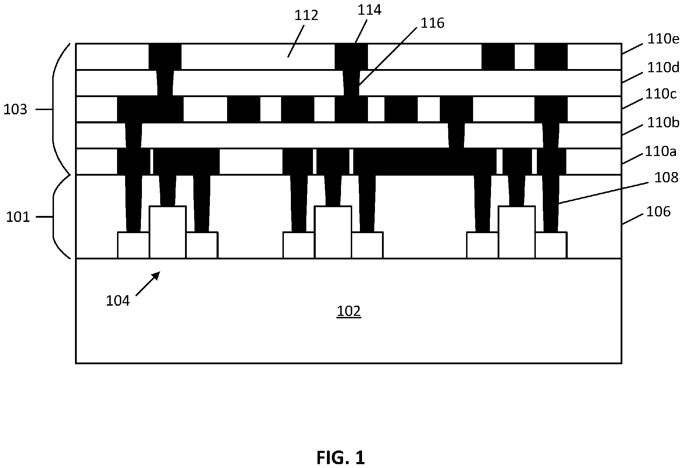

Figure 1 is a cross-sectional view that illustrates an example portion of an integrated circuit having an interconnect region above a plurality of semiconductor devices, in accordance with an embodiment of the present disclosure. The semiconductor devices in this example are non-planar metal oxide semiconductor (MOS) transistors, such as tri-gate or gate-all-around (GAA) transistors, although other transistor topologies and types can also benefit from the techniques provided herein, as will be appreciated (e.g., planar transistors, forksheet transistors, thin film transistors, or any other transistors to which contact can be made).

According to some embodiments, the integrated circuit includes a device region 101 (sometimes referred to as a device layer), and an interconnect region 103 over the device region 101. Device region 101 may include a plurality of semiconductor devices 104 along with one or more other layers or structures associated with the semiconductor devices 104. For example, device region 101 can also include one or more dielectric layers 106 that surround active portions or contacts of the semiconductor devices 104. Device region 101 may also include one or more conductive contacts 108 that provide electrical contact to transistor elements such as gate structures, drain regions, or source regions. Conductive contacts 108 include, for example, tungsten, although other metal or metal alloy materials may be used as well. Conductive contacts may also be a part of, or otherwise include, what is sometimes called a local interconnect, which is considered part of the device layer and usually formed prior to any backend processing.

In some embodiments, device region 101 is formed on or over a substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, backside processing is used to remove substrate 102 and form any number of backside interconnect layers.

Interconnect region 103 includes a plurality of interconnect layers 110a - 110e stacked over one another. Each interconnect layer can include a dielectric material 112 along with one or more different conductive features. Dielectric material 112 can be any dielectric, such as silicon oxide, silicon oxycarbide, silicon nitride, or silicon oxynitride. Dielectric material 112 may be deposited using any known dielectric deposition technique such as chemical vapor deposition (CVD), plasma-enhanced chemical vapor deposition (PECVD), flowable CVD, spin-on dielectric, or atomic layer deposition (ALD). The one or more conductive features can include conductive traces 114 and conductive vias 116 arranged in any pattern across the interconnect layers 110a - 110e to carry signal and/or power voltages to/from the various semiconductor devices 104. A conducive via, such as conductive via 116, may extend through an interconnect layer to connect between conductive traces on an upper interconnect layer and a lower interconnect layer. In other cases, a via 116 may only extend part way through a given interconnect layer. Although interconnect region 103 is illustrated with only five interconnect layers, any number of interconnect layers can be used within interconnect region 103. Also, this example shows vias and lines in different interconnect layers, in both single and dual damascene configurations. In other examples, vias and lines may also exist within the same interconnect layer, such as in the case of some dual damascene configurations.

Any of conductive traces 114 and conductive vias 116 can include any number of conductive materials, with some examples including copper, ruthenium, tungsten, cobalt, molybdenum, and alloys thereof. In some cases, any of conductive traces 114 and conductive vias 116 include a relatively thin liner or barrier, such as titanium nitride, titanium silicide, tungsten carbo-nitride (WCN), PVD or ALD tungsten, or tantalum nitride. As will be discussed in more detail herein, any of conductive vias 116 may include a MIM structure as part of the conductive via to provide an anti-fuse element within interconnect region 103.

It should be noted that each of the various conductive vias 116 and conductive contacts 108 are shown with tapered profiles to indicate a more natural appearance due to the etching process used to form the openings. Any degree of tapering may be observed depending on the etch parameters used and the thickness of the dielectric layer being etched through. Furthermore, conductive vias may be stacked one over the other through different dielectric layers of interconnect region 103. However, in some examples, a single via recess may be formed through more than one dielectric layer yielding a taller, more tapered conductive via that extends through two or more dielectric layers.

The various interconnect layers of interconnect region 103 may not all be the same thickness. According to some embodiments, the interconnect layers increase in thickness moving upwards towards the top of interconnect region 103. Thus, the top-most interconnect layer may have the greatest thickness while the bottom-most interconnect layer may have the smallest thickness. In some examples, the top-most interconnect layer may have a thickness in the range of several micrometers (e.g., 1 - 4 µm), while the bottom-most interconnect layer may have a thickness of less than 50 nm.

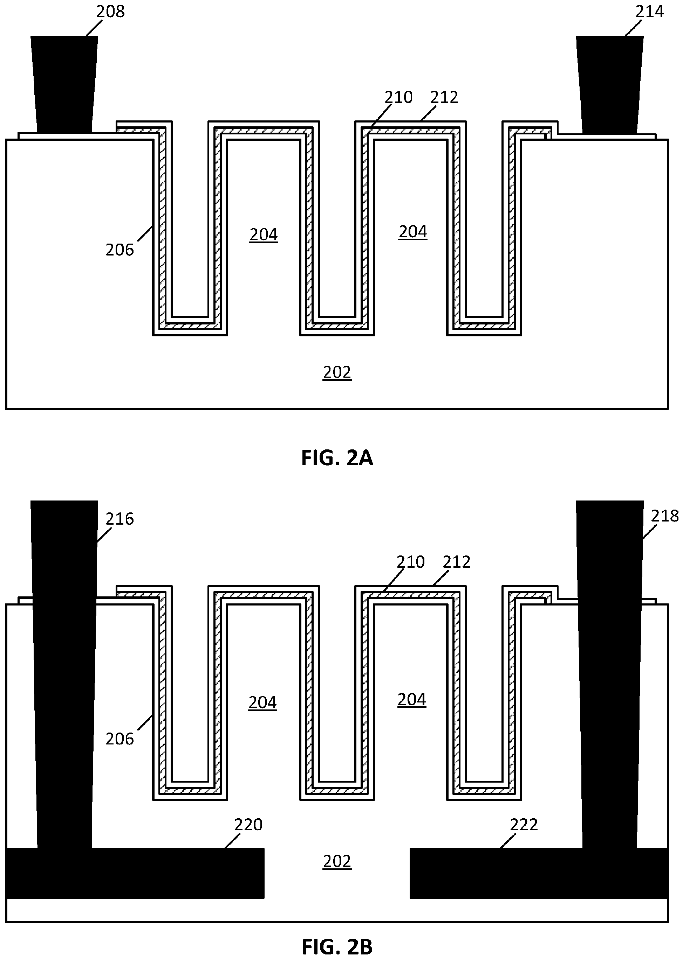

Figure 2A illustrates a more detailed cross-section view of a given interconnect layer having a MIM trench capacitor formed within it, according to some embodiments. The interconnect layer may include a dielectric layer 202 having a thickness that defines the thickness of the interconnect layer. According to some embodiments, dielectric layer 202 has a total thickness of between about 400 nm and 4000 nm. Dielectric layer 202 may be any suitable dielectric material, such as silicon dioxide. As evidenced by its thickness, the illustrated interconnect layer may be one of the upper interconnect layers of interconnect region 103. For example, the interconnect layer may be one of the top three interconnect layers of interconnect region 103.

Note that the illustrated interconnect layer can also include via structures and metal lines at other locations within the interconnect layer. Other features may also be included. For instance, there may be a relatively thin etch stop layer (e.g., silicon nitride having a thickness in the range of 2 nm to 6 nm) either along the top or bottom surface of dielectric layer 202. Any number of configurations will be apparent in light of this disclosure.

According to some embodiments, a plurality of dielectric fins 204 are provided within dielectric layer 202. Dielectric fins 204extend lengthwise into and out of the page to form trenches between them. According to some embodiments, dielectric fins 204 have a height between about 200 nm and about 2000 nm. Dielectric fins 204 may be formed directly from the dielectric material of dielectric layer 202 (e.g., formed via etching dielectric layer 202), or may be formed from patterning a different dielectric layer deposited on dielectric layer 202. A top surface of dielectric fins 204 may be substantially coplanar with a top surface of a remainder of dielectric layer 202.

The MIM capacitor includes a dielectric material sandwiched between two electrodes. According to some embodiments, the MIM capacitor includes a continuous structure that extends from a first location on the top surface of dielectric layer 206, and along the sidewall and top surfaces of each of the dielectric fins, to a second location on the top surface of dielectric layer 206. In the example case shown, a first electrode 206 continuously runs along the sidewalls and top surfaces of dielectric fins 204. First electrode 206 may also contact a top surface of dielectric layer 202 beyond the trenches, as part of its continuous nature. According to some such embodiments, first electrode 206 extends further along the top surface of dielectric layer 202 on one side of the plurality of trenches compared to the other side. The extended portion or tail of first electrode 206 provides a landing site for a first topside contact 208, according to some embodiments. First contact 208 may include any suitable conductive material, such as tungsten, ruthenium, titanium, tantalum, cobalt, molybdenum, or copper.

First electrode 206 may be any suitable conductive material, such as tungsten, ruthenium, cobalt, molybdenum, titanium, or copper. First electrode 206 may directly contact the dielectric material of dielectric fins 204 and dielectric layer 202, or a different material may be interposed between first electrode 206 and dielectric fins 204/dielectric layer 202. For example, a barrier layer including tantalum or titanium may be between first electrode 206 and the dielectric material of dielectric fins 204/dielectric layer 202. In another example, a different dielectric layer, such as silicon nitride, may be present between first electrode 206 and the dielectric material of dielectric fins 204/dielectric layer 202. First electrode 206 may have any suitable thickness depending on the application. In some examples, first electrode 206 has a thickness between about 20 nm and about 100 nm.

According to some embodiments, a dielectric structure 210 is on first electrode 206 at least within the trenches adjacent to dielectric fins 204. In some examples, dielectric structure 210 follows first electrode 206 along the sidewalls and top surfaces of dielectric fins 204. In some embodiments, dielectric structure 210 also follows at least a portion of first electrode 206 onto a top surface of dielectric layer 202 on either or both sides of the plurality of trenches, as part of its continuous nature. Dielectric structure 210 may represent any number of dielectric layers that make up the capacitor dielectric. According to some embodiments, dielectric structure 210 includes at least one high-k dielectric material, such as a material with a dielectric constant equal to or greater than that of silicon nitride. In one example, dielectric structure 210 includes a layer of hafnium oxide or aluminum oxide. Dielectric structure 210 may have any suitable thickness depending on the application. In some examples, dielectric structure 210 has a thickness between about 2 nm and about 50 nm.

According to some embodiments, a second electrode 212 is on dielectric structure 210 at least within the trenches adjacent to dielectric fins 204. In some examples, second electrode 212 follows dielectric structure 210 along the sidewalls and top surfaces of dielectric fins 204. Second electrode 212 may also contact a top surface of dielectric layer 202 beyond the trenches, as part of its continuous nature. According to some embodiments, second electrode 212 extends further along the top surface of dielectric layer 202 on one side of the plurality of trenches compared to the other side. The extended portion or tail of second electrode 212 provides a landing site for a second topside contact 214, according to some embodiments. Second contact 214 may have similar properties to first contact 208. Second electrode 212 may be any suitable conductive material, such as tungsten, ruthenium, cobalt, molybdenum, titanium, or copper. In the illustrated example, first electrode 206 extends further on the top surface of dielectric layer 202 on the left side of the plurality of trenches and second electrode 212 extends further on the top surface of dielectric layer 202 on the right side of the plurality of trenches. Due to the sandwich layout with dielectric structure 210, second electrode 212 is separated from first electrode 206 by dielectric structure 210. Second electrode 212 may have any suitable thickness. In some examples, second electrode 212 has a thickness between about 20 nm and about 100 nm. Due to the continuous capacitor layers extending from a first location on dielectric layer 202, and following the shape of the trenches, to a second location on the dielectric layer 202, the MIM capacitor has a three-dimensional serpentine or accordion shape that increases the surface area between the electrodes within a relatively small two-dimensional footprint, thus requiring less space in the X-direction (left to right on the page) and/or in the Y-direction (into and out of the page). Likewise, another example configuration may use less space in the Z-direction (up and down the page) if more space is used in the X and/or Y directions. Other such variations can be used as well, so as to provide a capacitor structure with a desired amount of capacitance.

As noted above, various contact schemes may be used to provide electrical contact to each of first electrode 206 and second electrode 212. Figure 2B illustrates an example where via structures 216 and 218 are formed through at least a portion of a thickness of dielectric layer 202 to contact conductive traces 220 and 222, respectively. According to some embodiments, via structure 216 provides a conductive path between first electrode 206 and conductive trace 220 and via structure 218 provides a conductive path between second electrode 212 and conductive trace 222. Via structures 216/218 may include the same conductive materials as contacts 208/214.

Conductive traces 220/222 may include any suitable conductive material such as tungsten, ruthenium, titanium, tantalum, cobalt, molybdenum, or copper. According to some embodiments, conductive traces 220/222 may be on the same level with each other (e.g., substantially coplanar with each other) beneath dielectric fins 204. Conductive traces 220/222 may be part of the same interconnect layer as the MIM capacitor (e.g., formed within dielectric layer 202), or may be part of a lower interconnect layer beneath dielectric layer 202.

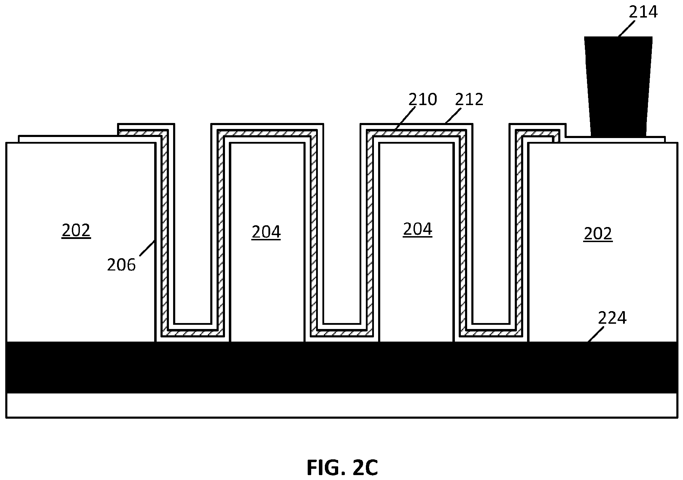

Figure 2C illustrates another example where second electrode 212 is coupled to topside contact 214, while a conductive trace 224 contacts first electrode 206. According to some embodiments, first electrode 206 directly contacts conductive trace 224 at the bottom of the trenches adjacent to dielectric fins 204. Conductive trace 224 may be part of the same interconnect layer as the MIM capacitor (e.g., formed within dielectric layer 202), or may be part of a lower interconnect layer beneath dielectric layer 202. Conductive trace 224 may include any suitable conductive material such as tungsten, ruthenium, cobalt, molybdenum, or copper.

In the examples of Figures 2A-C, first electrode 206 runs continuously from a first location on the top surface and along side and bottom walls of the recesses to a second location on the top surface of dielectric layer 202. Similarly, capacitor dielectric layer 210 runs continuously along first electrode 206, such that capacitor dielectric layer 210 follows the first electrode at least along the side and bottom walls of the recesses to a third location on the top surface of dielectric layer 202, adjacent to the second location. Likewise, the second electrode 212 runs continuously along capacitor dielectric layer 210, such that second electrode 212 follows capacitor dielectric layer 210 at least along the side and bottom walls of the recesses to a fourth location on the top surface of dielectric layer 202. As further shown in the examples of Figures 2A-C, the third location is between the second and fourth locations.

### Fabrication Methodology

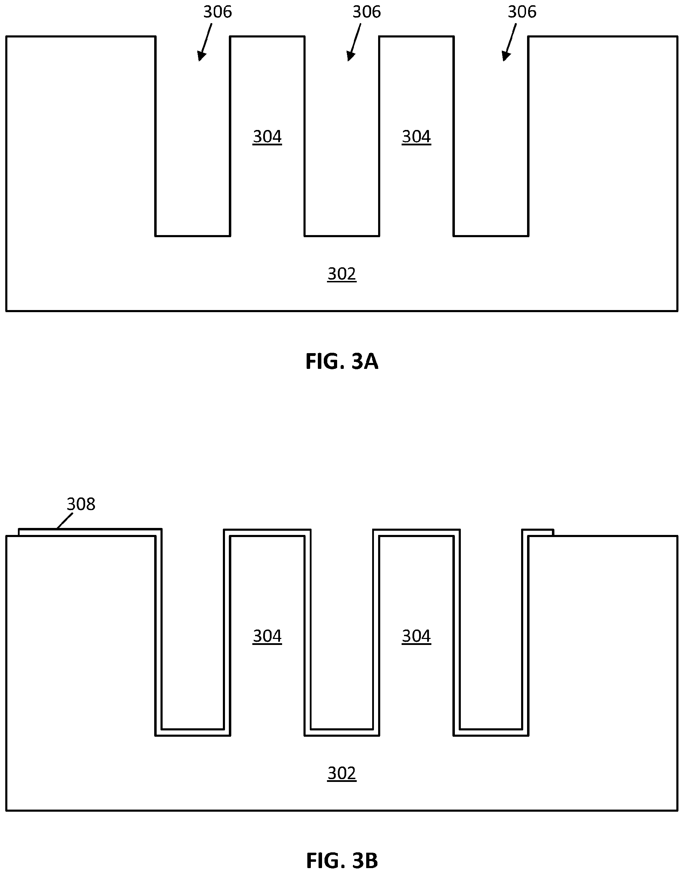

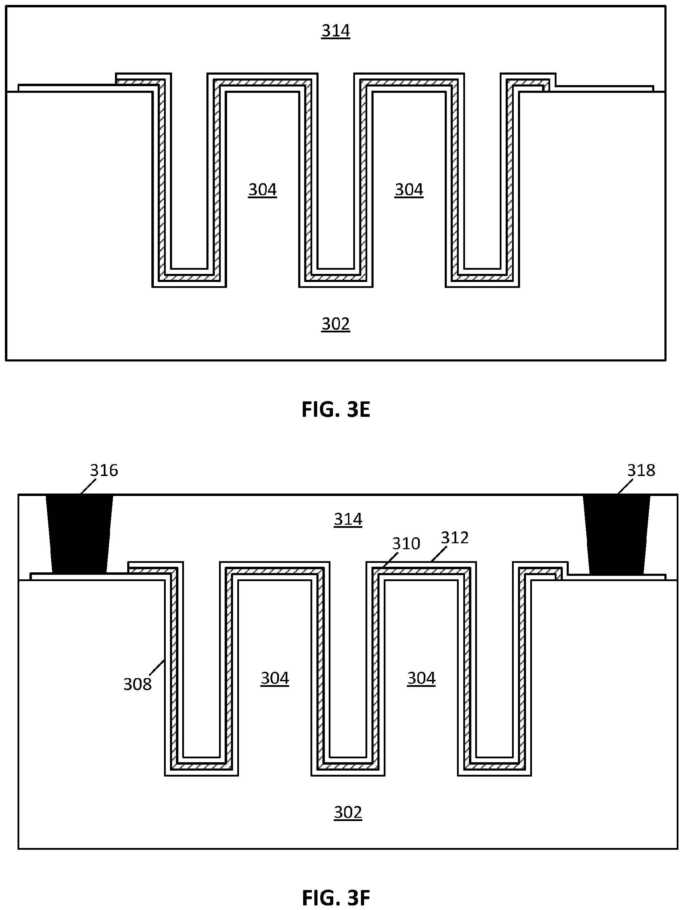

Figures 3A - 3F are cross-sectional views that collectively illustrate an example process for forming a portion of an interconnect region of an integrated circuit, in accordance with an embodiment of the present disclosure. Each figure shows an example structure that results from the process flow up to that point in time, so the depicted structure evolves as the process flow continues, culminating in the MIM capacitor structure shown in Figure 3F, which is similar to the structure illustrated in Figure 2A. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 3A is a cross sectional view taken through an interconnect layer of a plurality of stacked interconnect layers. Accordingly, the illustrated interconnect layer may be at any position within interconnect region 103. As noted above, the illustrated interconnect layer may be one of the upper interconnect layers, such as one of the top three interconnect layers of interconnect region 103. The interconnect layer includes a dielectric layer 302 that may include any suitable dielectric material, such as silicon dioxide, silicon oxynitride, or silicon oxycarbide. Dielectric layer 302 may be formed using any known dielectric deposition technique, such as CVD, PECVD, flowable CVD, spin-on dielectric, or ALD. Dielectric layer 302 may have a height between about 400 nm and about 4000 nm.

According to some embodiments, a plurality of parallel fins 304 are formed within dielectric layer 302. An etching process may be performed using a patterned mask to protect some areas of dielectric layer 302 while exposing other areas to be recessed via the etch. Any suitable anisotropic etching process, such as RIE, may be used to form trenches 306 within dielectric layer 302. Dielectric fins 304 (and similarly trenches 306) may have a height between about 200 nm and about 2000 nm, depending on the desired size of the capacitor. Other heights may be used as well. According to some embodiments, trenches 306 may have a substantially constant pitch from one another across the page while extending into and out of the page for any desired distance.

Figure 3B is a cross sectional view of the structure depicted in Figure 3A, after formation of a first electrode 308, according to some embodiments. First electrode 308 may include copper or tungsten that is deposited using any one of electroplating, electroless plating, CVD, or PECVD, to name a few examples. Any other suitable conductive materials may be used as well (e.g., aluminum, ruthenium, cobalt, molybdenum). According to some embodiments, first electrode 308 is deposited directly on all surfaces within trenches 306 as well as on the top surfaces of fins 304 and dielectric layer 302. In some other embodiments, barrier layer or other dielectric layer is first deposited on the exposed surfaces of fins 304 and trenches 306, and first electrode 308 is deposited onto the barrier layer or other dielectric layer.

According to some embodiments, first electrode 308 is patterned using any suitable lithography process such that first electrode 308 extends further on the top surface of dielectric layer 302 on one side of the plurality of fins compared to the opposite side. In the illustrated example, the left side of first electrode 308 extends further on the top surface of dielectric layer 302 compared to the right side of first electrode 308. According to some embodiments, first electrode 308 is deposited to a thickness between about 20 nm and about 100 nm.

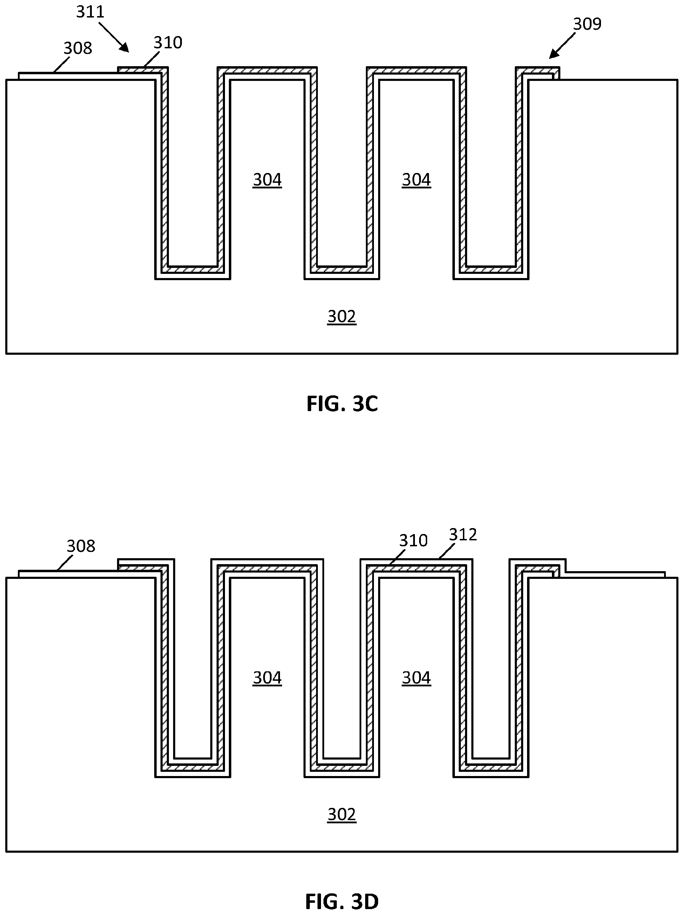

Figure 3C is a cross sectional view of the structure depicted in Figure 3B, after formation of dielectric structure 310 on first electrode 308, according to some embodiments. Dielectric structure 310 may represent any number of deposited dielectric layers. In some examples, dielectric structure 310 includes a layer of hafnium oxide or any other suitable high-k dielectric material. Dielectric structure 310 may be deposited using any suitable dielectric deposition technique, such as CVD, PECVD, ALD, or spin-on dielectric.

According to some embodiments, dielectric structure 310 follows first electrode 308 over all surfaces within trenches 306 and over fins 304. Dielectric structure 310 may be patterned using any suitable lithographic technique such that dielectric structure 310 completely covers the shorter side of first electrode 308 (e.g., at location 309) on the top surface of dielectric layer 302 and exposes a portion of the longer side of first electrode 308 (e.g., at location 311) on the top surface of dielectric layer 302. According to some embodiments, dielectric structure 310 is deposited to a thickness between about 2 nm and about 50 nm.

Figure 3D is a cross sectional view of the structure depicted in Figure 3C, after formation of a second electrode 312 on dielectric structure 310, according to some embodiments. Second electrode 312 may include copper or tungsten that is deposited using any one of electroplating, electroless plating, CVD, or PECVD, to name a few examples. Any other suitable conductive materials may be used as well (e.g., aluminum, ruthenium, cobalt, molybdenum). In some examples, first electrode 308 and second electrode 312 include the same conductive material. According to some embodiments, second electrode 312 follows dielectric structure 310 over all surfaces within trenches 306 and over fins 304.

According to some embodiments, second electrode 312 is patterned using any suitable lithography process such that second electrode 312 extends further on the top surface of dielectric layer 302 on one side of the plurality of fins compared to the opposite side. In the illustrated example, the right side of second electrode 312 extends further on the top surface of dielectric layer 302 compared to the right side of second electrode 312. In the illustrated example, first electrode 308 extends further on the top surface of dielectric layer 302 on one side of the plurality of trenches 306 and second electrode 312 extends further on the top surface of dielectric layer 302 on the opposite side of the plurality of trenches 306. Due to the sandwich layout with dielectric structure 310, second electrode 312 is separated from first electrode 308 by dielectric structure 210 along all surfaces within trenches 306 and on fins 304. According to some embodiments, second electrode 312 is deposited to a thickness between about 20 nm and about 100 nm.

Figure 3E is a cross sectional view of the structure depicted in Figure 3D following the formation of an additional dielectric layer 314 over dielectric layer 302, according to some embodiments. Dielectric layer 314 may include any suitable dielectric material, such as the same dielectric material as dielectric layer 302. According to some embodiments, dielectric layer 314 fills in any remaining space within trenches 306 following the formation of the MIM capacitor structure. A top surface of dielectric layer 314 may be planarized using any standard polishing technique, such as chemical mechanical polishing (CMP).

Figure 3F is a cross sectional view of the structure depicted in Figure 3E following the formation of contacts 316/318 through dielectric layer 314, according to some embodiments. Contacts 316/318 may include any suitable conductive material, such as tungsten, copper, cobalt, ruthenium, or molybdenum. In some examples, contacts 316/318 include a barrier layer having titanium or tantalum that is deposited first and followed by a metal fill formed on the barrier layer. In the illustrated example, contact 316 makes electrical contact to first electrode 308 and contact 318 makes electrical contact to second electrode 312.

As discussed above with reference to Figures 2B and 2C, many other electrode contact schemes can be used. In some embodiments, one or both of contacts 316/318 continue through the corresponding first electrode 308 or second electrode 312 to make contact with respective lower conductive traces beneath fins 304 (such as shown in Figure 2B). The lower conductive traces may have been formed within a previous interconnect layer beneath dielectric layer 302, or may have been formed within a portion of dielectric layer 302 prior to the formation of fins 304 and trenches 306. In some other embodiments, contact 316 is omitted and first electrode 308 instead directly contacts a lower conductive trace beneath fins 304 (such as shown in Figure 2C). Accordingly, contact 316 may be formed directly on the lower conductive trace at the bottom of trenches 306. Similar to the above example, the lower conductive trace may have been formed within a previous interconnect layer beneath dielectric layer 302, or may have been formed within a portion of dielectric layer 302 prior to the formation of fins 304 and trenches 306.

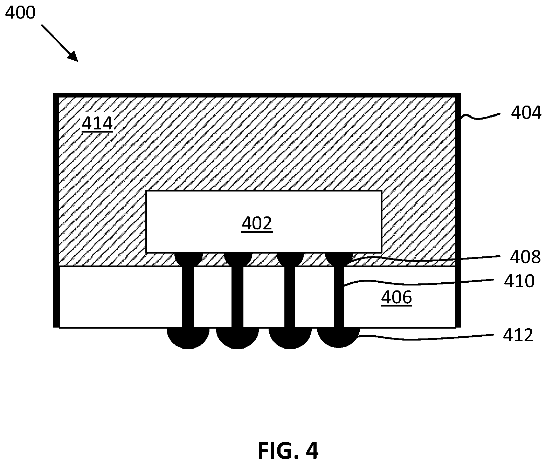

Figure 4 illustrates an example embodiment of a chip package 400, in accordance with an embodiment of the present disclosure. As can be seen, chip package 400 includes one or more dies 402. One or more dies 402 may include at least one integrated circuit having a structure as described in any of the aforementioned embodiments. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Example System

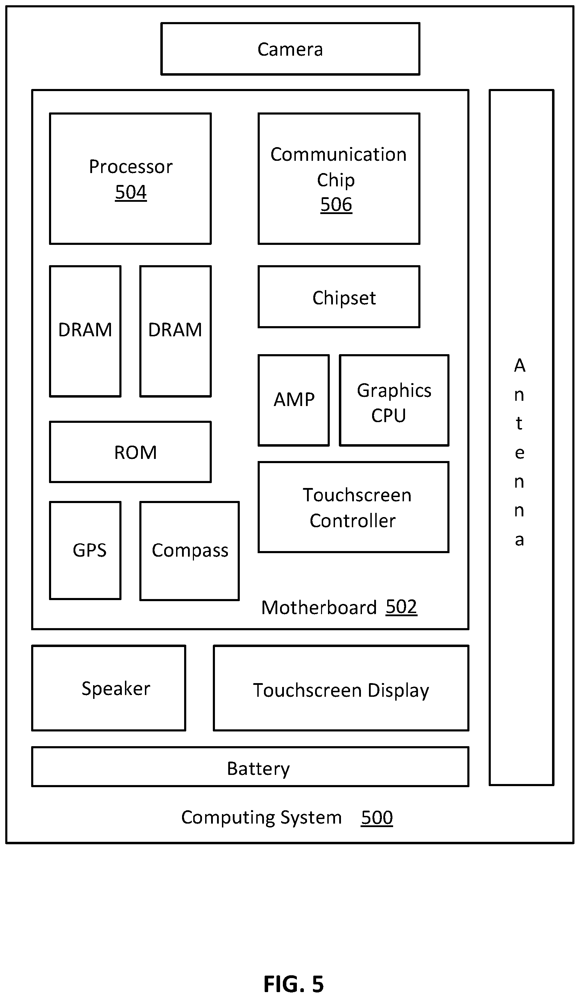

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit having interconnect structures that have one or more MIM trench capacitors in the interconnect region). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a plurality of semiconductor devices, an interconnect region above the plurality of semiconductor devices having a plurality of interconnect layers, and a metal-insulator-metal (MIM) capacitor in the interconnect region. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer is conformal on the first electrode along the sidewalls and the top surfaces of the plurality of parallel dielectric fins, and the second electrode is conformal on the capacitor dielectric layer along the sidewalls and the top surfaces of the plurality of parallel dielectric fins.

Example 2 includes the integrated circuit of Example 1, wherein each of the plurality of parallel dielectric fins have a height greater than 1 micrometer.

Example 3 includes the integrated circuit of Example 1 or 2, wherein the plurality of parallel dielectric fins are part of a dielectric layer in an interconnect layer of the plurality of interconnect layers.

Example 4 includes the integrated circuit of Example 3, wherein the top surfaces of the plurality of parallel dielectric fins are substantially coplanar with a top surface of the dielectric layer.

Example 5 includes the integrated circuit of Example 3 or 4, wherein the first electrode extends along a top surface of the dielectric layer on one side of the plurality of parallel dielectric fins and the second electrode extends along a top surface of the dielectric layer on an opposite side of the plurality of parallel dielectric fins.

Example 6 includes the integrated circuit of Example 5, further comprising a first conductive contact on the first electrode over the top surface of the dielectric layer, and a second conductive contact on the second electrode over the top surface of the dielectric layer.

Example 7 includes the integrated circuit of Example 5, further comprising a first conductive layer and a second conductive layer, both beneath the MIM capacitor, wherein a first conductive via extends from the first electrode on the top surface of the dielectric layer to the first conductive layer, and a second conductive via extends from the second electrode on the top surface of the dielectric layer to the second conductive layer.

Example 8 includes the integrated circuit of any one of Examples 3-5, further comprising a conductive layer beneath the MIM capacitor and in contact with the first electrode.

Example 9 includes the integrated circuit of Example 8, wherein the second electrode extends along a top surface of the dielectric layer on one side of the plurality of parallel dielectric fins, and the integrated circuit further comprises a conductive contact on the second electrode over the top surface of the dielectric layer.

Example 10 includes the integrated circuit of any one of Examples 1-9, wherein the interconnect layer is one of the three topmost interconnect layers of the plurality of interconnect layers.

Example 11 includes the integrated circuit of any one of Examples 1-10, wherein the capacitor dielectric includes a high-k dielectric.

Example 12 includes the integrated circuit of any one of Examples 1-11, wherein the MIM capacitor is in more than one interconnect layer of the plurality of interconnect layers.

Example 13 includes the integrated circuit of any one of Examples 1-12, wherein the plurality of parallel dielectric fins includes three to ten parallel dielectric fins.

Example 14 includes the integrated circuit of any one of Examples 1-13, wherein the plurality of parallel dielectric fins define a first trench and a second trench, with one of the dielectric fins between the first trench and the second trench, and wherein the first electrode continuously runs along sidewalls of the first and second trenches and the top surfaces of the dielectric fin between the first and second trenches.

Example 15 is a printed circuit board that includes the integrated circuit of any one of Examples 1-14.

Example 16 is an electronic device that includes a chip package having one or more dies. At least one of the one or more dies includes an interconnect region above a plurality of semiconductor devices and having a plurality of interconnect layers, and a metal-insulator-metal (MIM) capacitor in an interconnect layer of the plurality of stacked interconnect layers. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer follows the first electrode along the sidewalls and the top surfaces of the plurality of parallel dielectric fins, and the second electrode follows the capacitor dielectric layer along the sidewalls and the top surfaces of the plurality of parallel dielectric fins.

Example 17 includes the electronic device of Example 16, wherein the plurality of parallel dielectric fins have a height greater than 1 micrometer.

Example 18 includes the electronic device of Example 16 or 17, wherein the interconnect layer comprises a dielectric layer and the plurality of parallel dielectric fins are part of the dielectric layer.

Example 19 includes the electronic device of Example 18, wherein the first electrode extends along a top surface of the dielectric layer on one side of the plurality of parallel dielectric fins and the second electrode extends along a top surface of the dielectric layer on an opposite side of the plurality of parallel dielectric fins.

Example 20 includes the electronic device of Example 19, wherein the at least one of the one or more dies further comprises a first conductive contact on the first electrode over the top surface of the dielectric layer, and a second conductive contact on the second electrode over the top surface of the dielectric layer.

Example 21 includes the electronic device of Example 19, wherein the at least one of the one or more dies further comprises a first conductive layer beneath the MIM capacitor and a second conductive layer beneath the MIM capacitor. A first conductive via extends from the first electrode on the top surface of the dielectric layer to the first conductive layer, and a second conductive via extends from the second electrode on the top surface of the dielectric layer to the second conductive layer.

Example 22 includes the electronic device of any one of Examples 16-19, wherein the at least one of the one or more dies further comprises a conductive layer beneath the MIM capacitor and in contact with the first electrode.

Example 23 includes the electronic device of Example 22, wherein the second electrode extends along a top surface of the dielectric layer on one side of the plurality of parallel dielectric fins, and the at least one of the one or more dies further comprises a conductive contact on the second electrode over the top surface of the dielectric layer.

Example 24 includes the electronic device of any one of Examples 16-23, wherein the interconnect layer is one of the three topmost interconnect layers of the plurality of interconnect layers.

Example 25 includes the electronic device of any one of Examples 16-24, further comprising a printed circuit board, wherein the chip package is attached to the printed circuit board.

Example 26 is an integrated circuit that includes a plurality of semiconductor devices, an interconnect region above the plurality of semiconductor devices and having a plurality of interconnect layers, an interconnect layer of the plurality of stacked interconnect layers, and a metal-insulator-metal (MIM) capacitor embedded in the dielectric layer. The interconnect layer includes a dielectric layer having a thickness of at least 1 micrometer. The MIM capacitor includes a first electrode running along sidewalls and top surfaces of a plurality of parallel dielectric fins, a capacitor dielectric layer on the first electrode, and a second electrode on the capacitor dielectric layer. The capacitor dielectric layer follows the first electrode along the sidewalls and the top surfaces of the plurality of parallel dielectric fins. The second electrode follows the capacitor dielectric layer along the sidewalls and the top surfaces of the plurality of parallel dielectric fins.

Example 27 includes the integrated circuit of Example 26, wherein the top surfaces of the plurality of parallel dielectric fins are substantially coplanar with a top surface of the dielectric layer.

Example 28 includes the integrated circuit of Example 26 or 27, wherein the first electrode extends along a top surface of the dielectric layer on one side of the plurality of parallel dielectric fins and the second electrode extends along a top surface of the dielectric layer on an opposite side of the plurality of parallel dielectric fins.

Example 29 includes the integrated circuit of Example 28, further comprising a first conductive contact on the first electrode over the top surface of the dielectric layer, and a second conductive contact on the second electrode over the top surface of the dielectric layer.

Example 30 includes the integrated circuit of Example 28, further comprising a first conductive layer and a second conductive layer beneath the MIM capacitor, wherein a first conductive via extends from the first electrode on the top surface of the dielectric layer to the first conductive layer, and a second conductive via extends from the second electrode on the top surface of the dielectric layer to the second conductive layer.

Example 31 includes the integrated circuit of any one of Examples 26-28, further comprising a conductive layer beneath the MIM capacitor and in contact with the first electrode.

Example 32 includes the integrated circuit of Example 31, wherein the second electrode extends along a top surface of the dielectric layer on one side of the plurality of parallel dielectric fins, and the integrated circuit further comprises a conductive contact on the second electrode over the top surface of the dielectric layer.

Example 33 includes the integrated circuit of any one of Examples 26-32, wherein the interconnect layer is one of the three topmost interconnect layers of the plurality of interconnect layers.

Example 34 is a printed circuit board that includes the integrated circuit of any one of Examples 26-33.

Example 35 is an integrated circuit that includes an interconnect layer having a conductive interconnect feature within a layer of dielectric material, and a metal-insulator-metal (MIM) capacitor. The conductive interconnect feature is a conductive via or a conductive line. The interconnect layer further includes a first recess and a second recess with each recess extending from a top surface of the layer of dielectric material toward a bottom surface of the layer of dielectric material. The MIM capacitor includes a first electrode that runs continuously from a first location on the top surface and along side and bottom walls of the first and second recesses to a second location on the top surface, a capacitor dielectric layer that runs continuously along the first electrode, and a second electrode that runs continuously along the capacitor dielectric layer. The capacitor dielectric layer follows the first electrode at least along the side and bottom walls of the first and second recesses to a third location on the top surface. The second electrode follows the capacitor dielectric layer at least along the side and bottom walls of the first and second recesses to a fourth location on the top surface. The third location is between the second and fourth locations.

Example 36 includes the integrated circuit of Example 35, wherein each of the first and second recesses has a height greater than 1 micrometer.

Example 37 includes the integrated circuit of Example 35 or 36, further comprising a first conductive contact on the first electrode, and a second conductive contact on the second electrode.

Example 38 includes the integrated circuit of Example 35 or 36, further comprising a first conductive layer and a second conductive layer, both beneath the MIM capacitor, wherein a first conductive via extends from the first electrode to the first conductive layer, and a second conductive via extends from the second electrode to the second conductive layer.

Example 39 includes the integrated circuit of Example 35 or 36, further comprising a conductive layer beneath the MIM capacitor and in contact with the first electrode.

Example 40 includes the integrated circuit of Example 39, further comprising a conductive contact on the second electrode.

Example 41 includes the integrated circuit of any one of Examples 35-40, wherein the interconnect layer is one of the three topmost interconnect layers of the plurality of interconnect layers.

Example 42 includes the integrated circuit of any one of Examples 35-41, wherein the capacitor dielectric includes a high-k dielectric.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit, comprising:
a plurality of semiconductor devices;
an interconnect region above the plurality of semiconductor devices, the interconnect region comprising a plurality of interconnect layers; and
a metal-insulator-metal (MIM) capacitor in the interconnect region, the MIM capacitor comprising
a first electrode running along sidewalls and top surfaces of a plurality of parallel dielectric fins;
a capacitor dielectric layer on the first electrode, such that the capacitor dielectric layer is conformal with the first electrode along the sidewalls and the top surfaces of the plurality of parallel dielectric fins; and
a second electrode on the capacitor dielectric layer, such that the second electrode is conformal with the capacitor dielectric layer along the sidewalls and the top surfaces of the plurality of parallel dielectric fins.

2. The integrated circuit of claim 1, wherein each of the plurality of parallel dielectric fins have a height greater than 1 micrometer.

3. The integrated circuit of claim 1 or 2, wherein the plurality of parallel dielectric fins are part of a dielectric layer in an interconnect layer of the plurality of interconnect layers.

4. The integrated circuit of claim 3, wherein the top surfaces of the plurality of parallel dielectric fins are substantially coplanar with a top surface of the dielectric layer.

5. The integrated circuit of claim 3 or 4, wherein the first electrode extends along a top surface of the dielectric layer on one side of the plurality of parallel dielectric fins and the second electrode extends along a top surface of the dielectric layer on an opposite side of the plurality of parallel dielectric fins.

6. The integrated circuit of claim 5, further comprising:
a first conductive contact on the first electrode over the top surface of the dielectric layer; and
a second conductive contact on the second electrode over the top surface of the dielectric layer.

7. The integrated circuit of claim 5, further comprising a first conductive layer and a second conductive layer, both beneath the MIM capacitor, wherein a first conductive via extends from the first electrode on the top surface of the dielectric layer to the first conductive layer, and a second conductive via extends from the second electrode on the top surface of the dielectric layer to the second conductive layer.

8. The integrated circuit of any one of claims 3 through 5, further comprising:
a conductive layer beneath the MIM capacitor and in contact with the first electrode.

9. The integrated circuit of claim 8, wherein the second electrode extends along a top surface of the dielectric layer on one side of the plurality of parallel dielectric fins, and the integrated circuit further comprises a conductive contact on the second electrode over the top surface of the dielectric layer.

10. The integrated circuit of any one of claims 1 through 9, wherein the interconnect layer is one of the three topmost interconnect layers of the plurality of interconnect layers.

11. The integrated circuit of any one of claims 1 through 10, wherein the capacitor dielectric includes a high-k dielectric.

12. The integrated circuit of any one of claims 1 through 11, wherein the MIM capacitor is in more than one interconnect layer of the plurality of interconnect layers.

13. The integrated circuit of any one of claims 1 through 12, wherein the plurality of parallel dielectric fins includes three to ten parallel dielectric fins.

14. The integrated circuit of any one of claims 1 through 13, wherein the plurality of parallel dielectric fins define a first trench and a second trench, with one of the dielectric fins between the first trench and the second trench, and wherein the first electrode continuously runs along sidewalls of the first and second trenches and the top surfaces of the dielectric fin between the first and second trenches.

15. A printed circuit board that includes the integrated circuit of any one of claims 1 through 14.
